# EUROPEAN PATENT SPECIFICATION

(11) **EP 1 173 629 B1**
(45) Date of publication and mention of the grant of the patent: **06.08.2003**
(21) Application number: 00910492.8
(22) Date of filing: 17.03.2000
(51) Int. Cl.: C23C 14/32, H01J 37/32

(54) **VACUUM CATHODIC ARC EVAPORATION PROCESS FOR THE PREPARATION OF WEAR RESISTANT COATINGS**
KATHODISCHES VAKUUM-BOGENVERDAMPFUNGSVERFAHREN FÜR DIE HERSTELLUNG VON VERSCHLEISSFESTEN BESCHICHTUNGEN
PROCEDE D'EVAPORATION SOUS VIDE A ARC CATHODIQUE POUR LA PREPARATION DE REVETEMENTS RESITANTS A L'USURE

(30) Priority: 24.03.1999 CZ 105499
(43) Date of publication of application: 23.01.2002
(73) Proprietor: SHM, S.R.O., 788 03 Novy Malin (CZ)
(72) Inventor: HOLUBAR, Pavel;, 787 01 Sumperk (CZ); JILEK, Mojmir, 787 01 Sumperk (CZ)
(74) Representative: Gallafent, Richard John
(86) International application number: CZ0000019
(87) International publication number: WO00056946

(56) References cited:
- EP-A- 0 511 153
- DE-A- 4 343 354
- US-A- 5 282 944
- US-A- 5 318 840
- GABRIEL H M: "VACUUM ARC DISCHARGES USED TO DEPOSIT HARD WEAR RESISTANT COATINGS ONTO TOOLS" PROCEEDINGS OF THE INTERNATIONAL SYMPOSIUM ON DISCHARGES AND ELECTRICAL INSULATION IN VACUUM,US,NEW YORK, IEEE, vol. SYMP. 15, 1992, pages 643-645, XP000342798 ISBN: 3-8007-1856-1
- DATABASE WPI Section Ch, Week 198641 Derwent Publications Ltd., London, GB; Class L02, AN 1986-268930 XP002141539 & JP 61 195975 A (SUMITOMO ELECTRIC IND CO), 30 August 1986 (1986-08-30)
- PATENT ABSTRACTS OF JAPAN vol. 1996, no. 03, 29 March 1996 (1996-03-29) & JP 07 310171 A (KOBE STEEL LTD), 28 November 1995 (1995-11-28)

## Description

This invention relates to the preparation of wear resistant coatings by a low voltage arc process, the cathode being located in a coating chamber, especially for carrying out this process.

Coatings of hard wear resistant layers applied on an object, usually a cutting tool, and made of other material, such as metal are known. Manufacturing such an object with subsequent application of a coating on its cutting areas can considerably improve the utility of the tool, especially its service life, and raise the cutting speed. Also a broader scope of applications is enabled wherein the tool would not be operable without such coatings. Various coatings are known, such as TiN, MoN, WN, TiC, Al₂O₃, Si₃N₄, B₄C, ZrN, HfN, AIN and their combinations in the form of multilayer coatings, such as TiN +Al₂O₃, or in the form of multicomponent coatings and their solid solutions, such as TiAIN, TiCN. The layers made thereof, however, have limited hardness and chemical as well as thermal stability, which hampers their utilisation for heavy duty tools.

Superhard layers on the basis of Ti-B-N are known that are prepared by application methods called Physical Vapour Deposition (further only PVD). Where the PVD technology apparatus uses a gas as the source of boron, such as B₃N₃H₆, BCl₃ etc., a combined technology is already involved, PVD/Plasma Assisted Chemical Vapour Deposition (hereafter PACVD), and boron and its compounds are deposited on the surface ofthe evaporating or sputtering PVD electrode intended for evaporation or pulverisation. On the one hand, this results in reducing the speed of coating, on the other hand the coating parameters may change uncontrollably; the so-called intoxication of the cathode can occur.

Technologies for depositing wear resistant TiAlSiN layers are known where metallic electrodes made separately of titanium and aluminium for Ti and Al vapour deposition are used, and either a metallic Si electrode or a gaseous component, such as SiH₄, is used as the Si source. Technologies are also known using TiAlSi alloys as a source of material. These technologies can not be efficiently applied if a low voltage arc is used for vapour deposition because the TiAlSi alloy, or possibly pure Si, is unsuitable for evaporation in a low voltage arc, due to the substantial increase of the number and size of macro particles. When gaseous Si, such as SiH₄, is used as the Si source, the process becomes unstable and problems concerning the maintenance of stable stoichiometry of the coating are seen to occur.

Also processes and apparatus are known for depositing protective layers onto objects by way of the above mentioned physical method, namely PVD, or by a chemical method, namely Chemical Vapour Deposition (further only CVD), or by a chemical method from gaseous phase in the presence of plasma, namely PACVD.

In the case of the PACVD method a process is generally used wherein the layer grows in a glow discharge, one electrode of which is located directly on the objects to be coated, i.e. the charge to be coated. The glow discharge burns directly in the gas mixture that is the source of the coating material. The disadvantage of this method resides in the irregularity of coating growth on the charge to be coated.

One of the solutions of the PVD method has been described and illustrated in the Czech patent specification No. 276840. According to this method the object to be coated is arranged in a vacuum coating chamber. The evaporation of the coating material located in the centre of the chamber is achieved by a low voltage electric arc, the evaporating material being one of the electrodes, namely the cathode. The objects to be coated are located close to the walls of the coating chamber, and negative voltage is applied to them. This results in accelerating positively charged ions directed to the objects to be coated. Modifying this negative voltage during the coating process can partially regulate the temperature of these objects. The evaporating electrode can be positioned in a magnetic field that accelerates the cathode spot and reduces the number of macro particles that are generated during the application of this technology.

The disadvantages of the previous embodiment reside in particular in that there is no way of controlling the regularity of the cathode spot motion over the surface of the whole cathode. That is why such a solution does not allow multicomponent coatings with a defined components ratio to be deposited in a controlled way.

The aim of the present invention is the creation of a process of producing a protective coating consisting of various layers, doing away, to the greatest possible extent with the drawbacks of the present art and allowing the establishment of various layers, possibly using different technologies, in one single process.

The process of creating a wear resistant coating on a substrate by deposition is achieved by evaporation caused by a low voltage arc in a reaction atmosphere by a physical method (PVD) and/or by a chemical method from a gaseous phase under the presence of plasma (PACVD), the ionisation of plasma for depositing by way of PACVD being ensured by the low voltage arc.

At least a part of the coating material is deposited on the substrate after evaporation from the cathode of the low voltage arc, a controlled source of magnetic field surrounding the cathode, which contributes to the regularity of the coating on a substrate.

Regarding the quality of coating it is significant that the formation takes place by evaporating from a cathode of which at least one part consists predominantly of an AlSi alloy with an atomic content of Si of between 3 and 30 %, the second part of the cathode containing at least some of the transition metal elements.

The substance of the apparatus for the preparation of wear resistant coatings by the low voltage arc process is a cathode located in a coating chamber where the axis of the cathode is basically vertical, and a source of magnetic field is applied to the cathode.

For the controllability of the magnetic field, it is important that the source of the magnetic field is at least one electromagnetic coil, and preferably has two electromagnetic coils provided for each cathode, said coils being coaxial with the cathode and connected with a control device.

An anode of the low voltage arc is provided for each electromagnetic coil at its outer side or, possibly, the coat of the electromagnetic coils operates as the anode of the low voltage arc, which contributes to the reliable burning of the low voltage arc.

The substantial benefit of a coating made according to the process of the present invention is the improvement of its physical characteristics.

The substantial benefit of the process according to the present invention resides in that it allows the production of hard and superhard coatings using the combined PVD/PACVD method, while substantially suppressing the intoxication of the electrode intended for evaporating material by the PVD method, such as in case of Ti-B-N coatings where a gaseous component, such as B₃N₃H₆, is being applied as a boron source.

Another advantage of the invention consists in that it allows the preparation ofmulticomponent coatings where the proportions of the separate components of the coating are continuously adjustable directly in the course of the process, such as TiAIN layers with a continuously adjustable Ti:Al ratio.

One of the advantages of the invention consists in that it allows layers with high B and N contents with good adhesion to be prepared.

The invention is beneficial also in that it allows TiAlSiN layers to be prepared by the PVD method by way of low voltage arc technology.

Another preferable embodiment of the invention resides in that if a conductive component is created by PACVD technology, the described apparatus allows also the exclusive application of the PACVD process, such as in the TiCl₄+N₂+H₂ mixture for producing a TiN layer. The benefit of the PACVD process resides in the fact that the ionisation field of reaction components is separated from the field of depositing the actual layer on the substrate. This enables the elimination of one of the basic drawbacks of the PACVD technology, namely the irregularity of coating growth. The ionisation in this case is not brought about by glow discharge, but by the aid of a low voltage arc.

Apparatus for carrying out the invention are illustrated in the drawings where Fig. 1 shows a diagrammatical section of the coating chamber, Fig. 2 shows another embodiment of a part of the coating apparatus, and Fig. 3 an apparatus for carrying out the invention having two cathodes.

The coating chamber 1 accommodates, in its centre or its axis, an evaporating electrode of coating material, serving as cathode 2 of the low voltage arc having approximately the form of a cylinder that can be tapered at both ends. As a rule, the axis of cathode 2 is vertical. Both ends of the tapered parts of cathode 2 can be provided with pole shoes 3. The centre of the evaporating electrode, i.e. cathode 2, is created by the actual functional part 5. This functional part 5 can consist of a plurality of zones, each of them having different material composition. In a preferable embodiment the first zone 6 is of titanium and the second zone 7 of aluminium. Inlets 10 of reaction gases open into the coating chamber 1.

Cathode 2 is provided with a source of controlled magnetic field, which can be embodied, e.g., so as to consist of a hollow upper electromagnetic coil 11 and a hollow bottom electromagnetic coil 12 that are symmetrically arranged at both sides of cathode 2. Accordingly, cathode 2 is accommodated in a magnetic field created by both coils 11 and 12. The internal diameter of the coat of both electromagnetic coils 11 and 12 exceeds the external diameter of the evaporating electrode, i.e. cathode 2. The bodies of the electromagnetic coils 11 and 12 are accommodated at the upper wall 8 and the bottom wall 9 of the coating chamber 1, respectively. Both electromagnetic coils 11 and 12 have substantially cylindrical form and their winding ends at the beginning of the cylindrical part of the evaporating electrode, i.e. cathode 2. The described arrangement of electromagnetic coils 11 and 12 is a preferable embodiment. They can be arranged in a different way, e.g. cathode 2 can be accommodated inside the electromagnetic coil as its core.

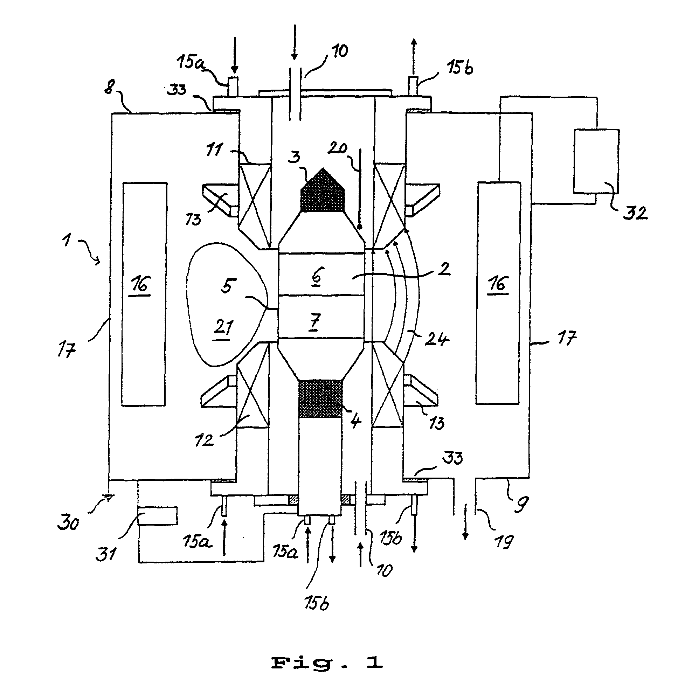

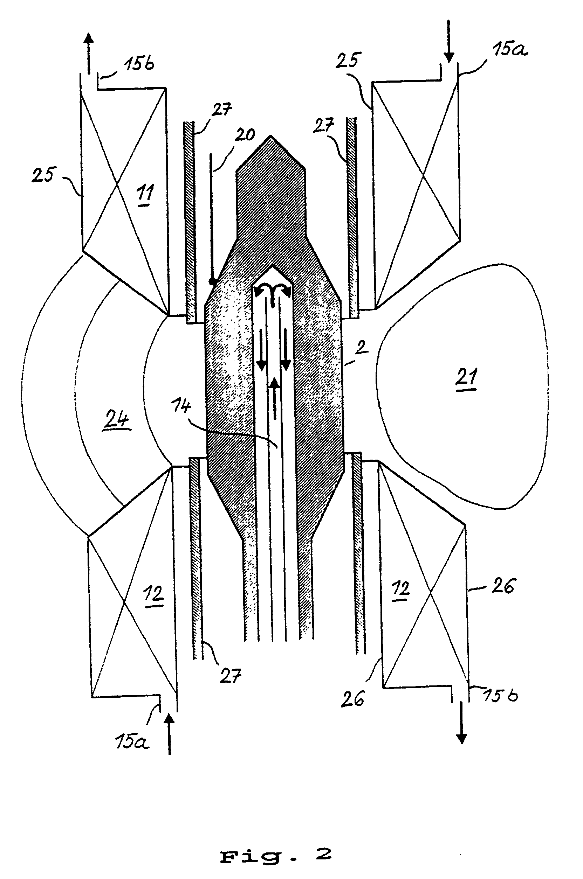

The coat of the electromagnetic coils 11 and 12 can create the anode of a low voltage arc (Fig. 2) and can be galvanically connected with the coating chamber 1, or it can be galvanically separated from the coating chamber 1, such as by insulation 33 (Fig. 1).

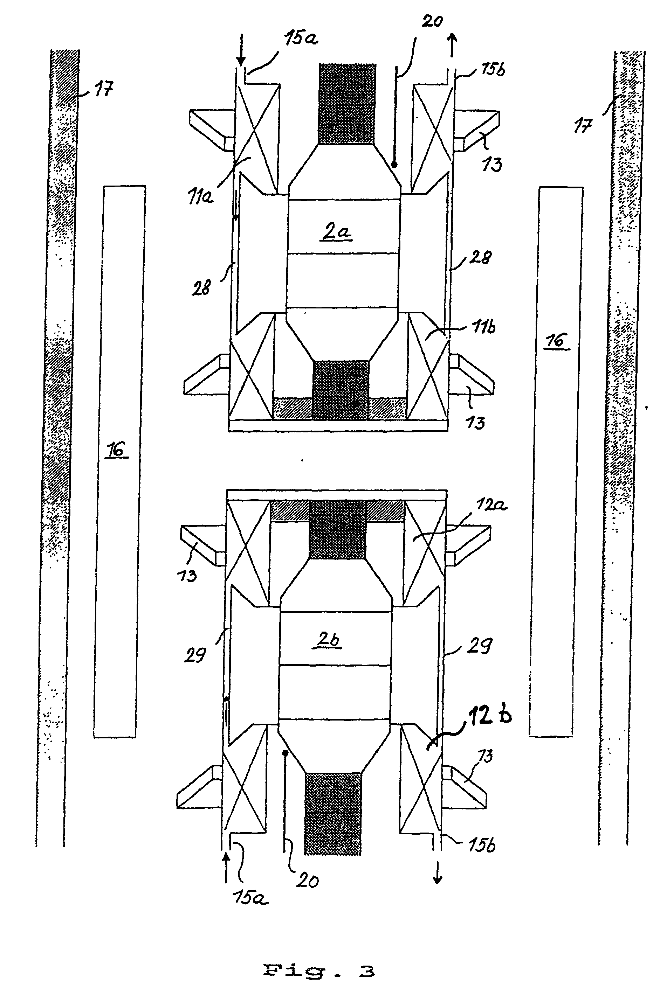

Embodiments according to Figs. 1 and 3 are provided with adjacent electrodes at the outer sides of each of the electromagnetic coils 11 and 12, this electrode according to the example of embodiment being anode 13 of the low voltage arc. Anode 13, the electromagnetic coils 11 and 12, including their coats, and cathode 2 are arranged substantially in one axis. Both electromagnetic coils 11 and 12, anode 13 as well as cathode 2 are cooled, cooling liquid being supplied into their coats or into the cavity 14 (Fig. 2) in the evaporating electrode/cathode 2 through the ducts 15a and drained through outlets 15b.

The objects to be coated/substrate 16 are accommodated in the current way in the coating chamber 1 close to its lateral wall 17 (Figs. 1 and 3). The coating chamber 1 is provided with evacuation outlet 19 for the connection of a [not illustrated] vacuum device, not illustrated, and is also electrically earthed by earthing 30 (Fig. 1). The evacuation outlet 19 serves also as outlet for inert gases. Adjacent to cathode 2 the ignition electrode 20 is arranged, in the example embodiment it is located at the upper part of cathode 2.

Prior to starting the apparatus chamber 1 of the coating apparatus should be sufficiently evacuated and then filled with the reaction gas, such as nitrogen or an inert gas, such as argon.

For starting the operation of the apparatus a negative coating voltage from the source 32 (Fig. 1) shall be applied to the substrate 16, i.e. on the subject to be coated, and the source 31 of the low voltage arc shall be applied between cathode 2 and anode 13. With the aid of ignition electrode 20 the low voltage arc is ignited in the current way. The burning area 21 (Figs. 1 and 2) is created by a ring surrounding cathode 2 and extending between both anodes 13 (Fig. 1) or between coats 25 and 26 of the electromagnetic coils 11 and 12 (Fig. 2), respectively. The negative bias of substrate 16 attracts positively charged particles evaporated from cathode 2 and ionised by the arc. Accordingly, a layer created by material of cathode 2 and the reaction gas is deposited on the surface of substrate 16. It can be summed up that at least a part of the coating material is deposited on the substrate after having been evaporated from cathode 2 of the low voltage arc, a controlled magnetic field surrounding cathode 2.

The current of the arc tends to range between 100 and 300 A, the voltage of the arc between 20 and 30 V, the current of positively ionised particles of the evaporated cathode deposited upon the substrate 16 is usually 4 - 20 A.

Also an electrical source, not illustrated, is connected to both electromagnetic coils 11 and 12, allowing them to generate a controlled electromagnetic field, as illustrated by line of force 24 in Figs. 1 and 2. Changing the electromagnetic field, i.e. controlling the current in electromagnetic coils 11 and 12, can serve to control the motion of the cathode spot over the surface of the functional part 5 of cathode 2. For this purpose the electromagnetic coils 11 and 12 are connected with a control device, not illustrated.

For preparing a TiAlSiN layer one part of cathode 2 consists of Ti and the other part of an Al-Si alloy containing Si within the range of 3-30 %; the reaction atmosphere is usually created by nitrogen under a pressure of 0.1 to 0.3 Pa. By controlling the current in the electromagnetic coils 11 and 12 the motion of the cathode spot over both zones 6 and 7 of cathode 2 can be controlled, which allows the adjustment of the stoichiometry of the deposited layer during the process. The vapour plating is to be carried out by evaporation from cathode 2, of which at least one part consists predominantly of an Al-Si alloy with an atomic content of Si in the range of 3 - 30 %. This method allows the creation of TiAlSiN layers with various Ti:AlSi ratios or, e.g., multilayers consisting of thin layers with various Ti:AlSi ratios. The second part of cathode 2 contains at least some transition metal elements, Ti being preferable.

Intensifying the magnetic field by increased current flow through the electromagnetic coils 11 and 12 results in stronger ionisation of gases in the region 21 of arc burning, and at the same time the voltage of the arc rises. If introducing a reaction gas suitable for the preparation of PACVD technology layers, such as TiCl₄, CH₄, B₃N₃H₆, SiH₄ etc. for the preparation of TiN, C, BN, Si₃N₄ etc into this area, the gas molecules become intensely ionised in this zone and accelerated towards the substrate 16 having negative voltage bias and, consequently, the layer growing on substrate 16 can be prepared partially by the PVD method, i.e. through evaporation of the material from the cathode of the low voltage arc, and partially by PACVD method, and namely thanks to the ionisation of the gaseous reaction components of the respective PACVD technologies in the burning area of the low voltage arc. Accordingly, this is a combined PVD-PACVD method. Consequently, the depositing takes place through vapour plating by the low voltage arc in a reaction atmosphere by way of a physical method (PVD) and/or by a chemical method from a gaseous phase under the presence of plasma (PACVD), the ionisation of plasma for the deposition by way of PACVD being effected by the low voltage arc.

Changing the intensity of the magnetic field can be used for continuous adjustment of the relative shares of the growing layers generated by contributions of the PVD and PACVD technologies. One of the advantages of this system resides in that the evaporated cathode 2 can be relatively small, which results in a high evaporating intensity of the coating material from a unit surface of cathode 2. This can substantially eliminate the intoxication of the cathode.

The described way can be used, by way of example, for preparing composite layers of TiN-Si₃N₄ where a part of TiN is created by the PVD method through evaporating Ti from cathode 2 in a nitrogen atmosphere, a part of Si₃N₄ being created by ionisation of SiH₄ in the burning area of the low voltage arc; by reacting with nitrogen, that is part of the reaction atmosphere, the Si₃N₄ component is formed. The proportion TiN:Si₃N₄ is usually in the range between 3:1 and 10:1.

In all the above examples Ti can be replaced by one of the transition metals, such as molybdenum or tungsten.

Another embodiment of an apparatus for carrying out the invention (Fig. 2) differs from the above described apparatus in that the function of the above mentioned anode 13 of the low voltage arc is performed by coats 25 and 26 of the electromagnetic coils 11 and 12 and, consequently, positive voltage of the source 31 of the low voltage arc is applied on these coats 25 and 26. For improving the burning stability of the low voltage arc a screening 27 is arranged inside the electromagnetic coils, e.g., in the form of cylinders. Such screening is beneficial, but not indispensable, and the apparatus according to the invention can be embodied without screening.

For improving the capacity of coating chamber 1 two evaporating electrodes can be accommodated in this chamber, and namely cathodes 2a and 2b (Fig. 3) and, possibly, also a plurality of cathodes 2a and 2b. In proportion to that also a corresponding number of electromagnetic coils, igniting electrodes, etc. should be used. The difference as compared with the embodiment according to Fig. 1 consists especially in that both electromagnetic coils 11a and 11b of the upper cathode 2a are attached to the upper wall 8 of the coating chamber 1 by a bracket, not illustrated, whereas both electromagnetic coils 12a and 12b of the bottom cathode 2b are attached to the bottom wall 9 of coating chamber 1 by a bracket, not illustrated. A preferable connection between the coats of electromagnetic coils 11a and 11b of the upper cathode 2a is ensured by interconnection 28 and between the coats of electromagnetic coils 12a and 12b of the bottom cathode 2b by another interconnection 29. Such interconnection 28 or 29 can be preferably embodied as a number of pipes, such as three pipes serving also for cooling the internal coils 11b and 12a, while being useful for supplying current to these electromagnetic coils 11a, 11b, 12a, and 12b.

Coatings prepared by the present inventive process are intended especially for creating hard and superhard surface layers on machining tools, e.g. cutting tools. It is also beneficial to provide such coatings on tools for milling, turning and boring as well as on tools for metal product finishing operations, such as honing and, possibly, also other tools requiring high resistance against abrasion and wear.

### List of parts

- 1: coating chamber
- 2: cathode
- 3: pole shoe
- 4: pole shoe
- 5: functional part
- 6: first zone
- 7: second zone
- 8: upper wall of coating chamber
- 9: bottom wall of coating chamber
- 10: inlet of reaction gas
- 11: upper electromagnetic coil
- 12: bottom electromagnetic coil
- 13: anode
- 14: hollow cathode
- 15a: inlet of coolant
- 15b: outlet of coolant
- 16: substrate - coated object
- 17: lateral wall of the coating chamber
- 19: evacuation outlet
- 20: ignition electrode
- 21: burning area of arc
- 24: lines of force of the magnetic field
- 25: coat of the electromagnetic coil 11
- 26: coat of the electromagnetic coil 12
- 27: shield
- 28: interconnection
- 29: interconnection
- 2a: upper cathode
- 2b: bottom cathode
- 11a: upper electromagnetic coil of the upper cathode
- 11b: bottom electromagnetic coil of the upper cathode
- 12a: upper electromagnetic coil of the bottom cathode
- 12b: bottom electromagnetic coil of the bottom cathode
- 30: grounding of the coating chamber
- 31: source of low voltage arc
- 32: source of substrate bias voltage
- 33: insulation

## Claims

1. A vacuum cathodic arc evaporation process for creating a wear resistant coating on a substrate **characterised by** using a cathode from which vapour is evaporated, at least a first part of which consists predominantly of an Al-Si alloy with a 3 to 30% atomic content of Si, and a second part of which contains at least some of the transition metal elements.

## Patentansprüche

1. Kathodisches Vakuum-Bogenverdampfungsverfahren zur Erzeugung einer verschleißfesten Beschichtung auf einem Substrat, **gekennzeichnet durch** den Einsatz einer Kathode, von der ein Dampf verdampft wird, von dem mindestens ein erster Teil hauptsächlich aus einer Al-Si-Legierung mit einem Gehalt von 3 - 30 Atom-% Si und ein zweiter Teil mindestens einige der Übergangsmetallelemente enthält.

## Revendications

1. Procédé d'évaporation sous vide par arc cathodique pour créer, sur un substrat, un revêtement résistant à l'usure, **caractérisé par le fait qu'**on utilise une cathode de laquelle on fait évaporer de la vapeur, dont au moins une première partie est essentiellement constituée d'un alliage Al-Si à teneur atomique de Si de 3 à 30%, et dont une seconde partie contient au moins quelques uns des éléments qui sont des métaux de transition.
